Europäisches Patentamt

European Patent Office

Office européen des brevets

(11) Veröffentlichungsnummer: **0 276 455**
**A1**

## EUROPÄISCHE PATENTANMELDUNG

(21) Anmeldenummer: 87118883.5

(51) Int. Cl.⁴: **G01R 31/32**

(22) Anmeldetag: **19.12.87**

(30) Priorität: **15.01.87 CH 133/87**

(43) Veröffentlichungstag der Anmeldung:
**03.08.88 Patentblatt 88/31**

(84) Benannte Vertragsstaaten:
**CH IT LI NL**

(71) Anmelder: **BBC Brown Boveri AG**
**Haselstrasse**
**CH-5401 Baden(CH)**

(72) Erfinder: **Fröhlich, Klaus, Dr.**
**Baldeggstrasse 11**
**CH-5400 Baden(CH)**

(54) **Prüfkreis.**

(57) Dieser Prüfkreis für die Prüfung des Abschaltvermögens von Hochspannungs-Gleichstromschaltern enthält eine Energiequelle (1) und einen von dieser beaufschlagten Induktivitätskreis (10).

Dieser Prüfkreis soll einfach und rasch aus einer vergleichsweise geringen Anzahl von Bauelementen aufgebaut werden können und soll wenig Wartungsaufwand erfordern. Dies wird dadurch erreicht, dass parallel zur Energiequelle (1) bzw. parallel zum Induktivitätskreis (10) mindestens eine zuschaltbare Induktivität ($L_2$) vorgesehen ist.

FIG.1

## Prüfkreis

Die Erfindung geht aus von einem Prüfkreis für die Prüfung des Abschaltvermögens von Hochspannungs-Gleichstromschaltern, mit einer Energiequelle und einem von der Energiequelle beaufschlagten Induktivitätskreis.

STAND DER TECHNIK

Es ist ein Prüfkreis (Patentgesuch Nr. 01626/86-6 beim Bundesamt für geistiges Eigentum, Bern/Schweiz) vorgeschlagen worden, der für die Prüfung von Hochspannungs-Gleichstromschaltern ausgelegt ist. Dieser Prüfkreis enthält eine Energiequelle, welche einen Induktivitätskreis beaufschlagt. Die Energiequelle besteht aus einer Wechselspannungsquelle, der ein Gleichrichter nachgeschaltet ist, und liefert einen Gleichstrom, der entsprechend den jeweiligen Prüfbedingungen auch einen überlagerten transienten Anteil enthalten kann. Im Prüfkreis sind mittels Hochspannungs-Leistungsschaltern zu-und abschaltbare ohmsche Widerstände vorgesehen, mit deren Hilfe der überlagerte transiente Anteil des Gleichstromes in seinem Verlauf beeinflusst werden kann.

Für den Aufbau des oben genannten Prüfkreises wird eine vergleichsweise grosse Grundfläche benötigt für das Aufstellen der Gleichrichter und der verschiedenen Hochspannungs-Leistungsschalter samt den damit zu-und abschaltbaren ohmschen Widerständen. Der Aufbau dieses Prüfkreises und der Unterhalt der Hochspannungs-Leistungsschalter ist arbeits-und zeitaufwendig.

DARSTELLUNG DER ERFINDUNG

Hier will die Erfindung Abhilfe schaffen. Die Erfindung, wie sie in den Ansprüchen gekennzeichnet ist, löst die Aufgabe, einen Prüfkreis für die Prüfung des Abschaltvermögens von Hochspannungs-Gleichstromschaltern anzugeben, welcher einfach und rasch aus einer vergleichsweise geringen Anzahl von Bauelementen aufgebaut werden kann und welcher wenig Wartungsaufwand erfordert.

Die durch die Erfindung erreichten Vorteile sind im wesentlichen darin zu sehen, dass dieser Prüfkreis aus in Hochleistungsprüfanlagen üblicherweise vorhandenen Elementen aufgebaut werden kann. Ferner genügen die dort gebräuchlichen Steuereinrichtungen für den Betrieb des erfindungsgemässen Prüfkreises. Die Verfügbarkeit dieses Prüfkreises ist vergleichsweise hoch, da lediglich ein Minimum an Hilfsschaltgeräten und sonstigen Hilfsmitteln benötigt wird, so dass einerseits die Anzahl der möglichen Fehlerquellen reduziert ist und andererseits weniger Revisionszeit aufgewendet werden muss.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnungen, welche lediglich einen Ausführungsweg darstellen, näher erläutert.

KURZE BESCHREIBUNG DER ZEICHNUNGEN

Es zeigen:

Fig. 1 eine erste Ausführungsform des erfindungsgemässen Prüfkreises,

Fig. 2 eine zweite Ausführungsform des erfindungsgemässen Prüfkreises,

Fig. 3 eine dritte Ausführungsform des erfindungsgemässen Prüfkreises und

Fig. 4 eine vereinfachte, skizzenhafte Darstellung des mit den Prüfkreisen gemäss den Fig. 1 bis 3 erzielbaren Gleichstromverlaufes.

Bei allen Figuren sind gleich wirkende Elemente mit gleichen Bezugszeichen versehen.

WEGE ZUR AUSFÜHRUNG DER ERFINDUNG

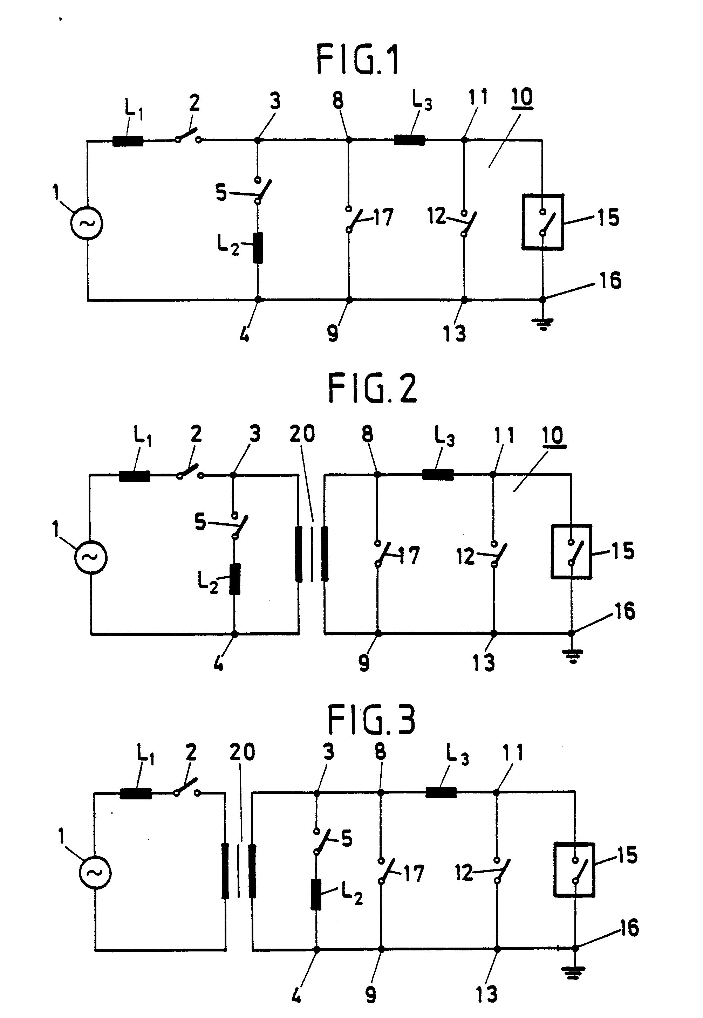

In der Fig. 1 ist ein einfacher, erfindungsgemässer Prüfkreis mit einer als Wechselspannungsquelle ausgebildeten Energiequelle 1 dargestellt. Ueber eine Induktivität $L_1$ und einen Draufschalter 2 führt der eine Pol der Energiequelle 1 zu einer Klemme 3, während ihr anderer Pol zu einer Klemme 4 führt. Zwischen den Klemmen 3 und 4 ist eine Reihenschaltung eines Einschaltgerätes 5 mit einer Induktivität $L_2$ angeordnet. Die Klemme 3 ist mit einer Klemme 8, die Klemme 4 mit einer Klemme 9 leitend verbunden. Die Klemmen 8 und 9 dienen als Eingangsklemmen zu einem Induktivitätskreis 10. Zwischen die Klemme 8 und eine Klemme 11 ist eine Induktivität $L_3$ geschaltet. Von der Klemme 11 führt ein erster, besonders impedanzarm ausgelegter Schaltungszweig über einen Notschalter 12 zu einer Klemme 13 und ein zweiter Schaltungszweig über einen Prüfschalter 15 zu einer starr geerdeten Klemme 16 und von dort weiter zur Klemme 13. Die Klemme 13 ist elektrisch leitend mit der Klemme 9 verbunden. Zwischen den Klemmen 8 und 9 ist ein Kurzschliesser 17 vorgesehen. Eine nicht dargestellte Steuereinrichtung sorgt für die zeitgenaue Steuerung der verschiedenen Schaltgeräte des Prüfkreises. Die für den sicheren Betrieb des Prüfkreises nötigen Schutz-, Hilfs-und Messeinrichtungen sind ebenfalls nicht dargestellt, da sie in derartigen Hochleistungsprüfanlagen stets vorhanden sind und routinemässig eingesetzt werden.

Zur Erläuterung der Wirkungsweise dieses Prüfkreises sei Fig. 1 näher betrachtet. Zunächst sind der Draufschalter 2, das Einschaltgerät 5, der Notschalter 12 und der Kurzschliesser 17 offen, der Prüfschalter 15 ist eingeschaltet. Die Energiequelle 1 kann als Wechselspannungsgenerator oder als Hochspannungsnetz mit entsprechendem Transformator oder als eine Kombination von Wechselspannungsgenerator mit einem Hochspannungsnetz ausgebildet sein. Die Induktivität $L_1$ stellt zum Teil die innere Induktivität der Energiequelle 1 und die Induktivität der Zuleitungen dar, sie kann durch Zuschaltung weiterer Induktivitäten dem jeweiligen Betriebsfall angepasst werden. Ueber dem Draufschalter 2 liegt die Wechselspannung an, welche die Energiequelle 1, die beispielsweise als Wechselstromgenerator ausgebildet ist, liefert. Genau in einem Nulldurchgang dieser Wechselspannung - schaltet der Draufschalter 2 ein und ein sinusförmiger Prüfstrom $i_p(t)$ beginnt zu fliessen. Dieser Prüfstrom $i_p(t)$ fliesst durch die Induktivitäten $L_1$ und $L_3$ und den Prüfschalter 15, er lädt die Induktivität $L_3$ auf. Die in $L_3$ gespeicherte Energie erreicht ihr Maximum, wenn der Prüfstrom $i_p(t)$ seinen ersten Scheitelwert erreicht.

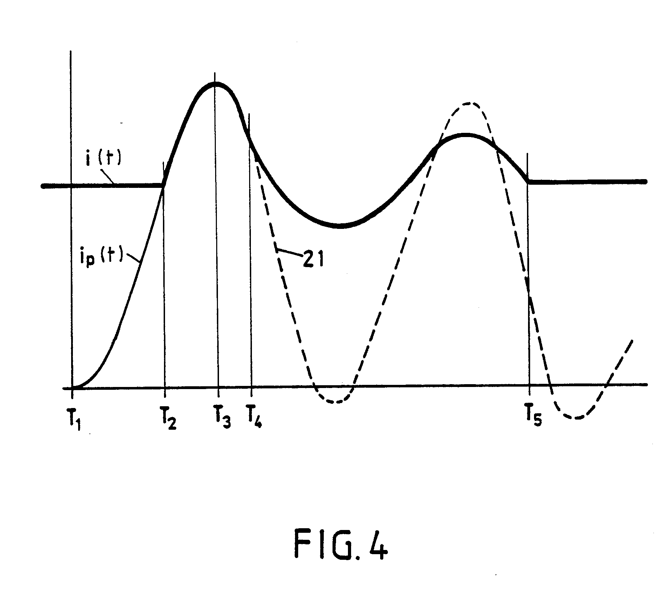

Zur weiteren Erläuterung der Wirkungsweise sei nun zusätzlich die Fig. 4 etwas näher betrachtet. Die Kurve i(t) stellt einen zeitlichen Verlauf eines Stromes in einem typischen Gleichstromnetzwerk dar. Zunächst fliesst ein konstanter Nennbetriebsstrom solange, bis in einem Zeitpunkt $T_2$ ein Fehler auftritt. Der Fehler hat einen transienten Anstieg des Stromes i(t) zur Folge, bis in einem Zeitpunkt $T_3$ dessen Strommaximum erreicht wird. Danach sinkt der Strom i(t) in Form einer Schwingung infolge eines regulierenden Einwirkens der das Gleichstromnetzwerk speisenden Ventilstationen wieder ab auf den Wert des Nennbetriebsstromes. Dieser Verlauf des Stromes i(t) wird durch den Prüfkreis nachgebildet.

Der Prüfstrom $i_p(t)$, der im Zeitpunkt $T_1$ zu fliessen beginnt, wird nun in seiner Kurvenform so angepasst, dass er ab dem Zeitpunkt $T_2$ den transienten Anstieg des Stromes i(t) nachbildet. Im Zeitpunkt $T_3$ erreicht der Prüfstrom $i_p(t)$ seinen ersten Scheitelwert und fällt dann sinusförmig ab bis zu einem Zeitpunkt $T_4$. Ab diesem Zeitpunkt $T_4$ würde der sinusförmige Prüfstrom $i_p(t)$, wie durch eine gestrichelte Linie 21 dargestellt, steiler abfallen als der transiente Anteil des Stromes i(t). Um jedoch eine weitere gute Anpassung des Prüfstromes $i_p(t)$ an den Verlauf des Stromes i(t) zu erreichen, wird im Zeitpunkt $T_4$ das Einschaltgerät 5 geschlossen und damit die Induktivität $L_2$ zugeschaltet. Die Grösse dieser Induktivität $L_2$ kann den jeweiligen Prüfbedingungen angepasst werden. Die beiden Induktvitäten $L_1$ und $L_2$ wirken als Spannungsteiler, der von der Energiequelle 1 gespeist wird. Dieser Spannungsteiler wird den jeweiligen Prüfbedingungen entsprechend ausgelegt. Infolge des Zuschaltens von $L_2$ nimmt der Prüfstrom $i_p(t)$ nicht den durch die Linie 21 angedeuteten weiteren Verlauf eines abklingenden asymmetrischen Wechselstromes, sondern er gleicht sich dem gewünschten transienten Verlauf des Stromes i(t) an. Das Zuschalten von $L_2$ bewirkt eine Amplitudenverkleinerung des Wechselanteils des Prüfstromes $i_p(t)$, und zwar im Verhältnis von $L_1$ zu $L_2$. Der Gleichstromanteil des Prüfstromes $i_p(t)$ wird dagegen nicht beeinflusst, da die als Energiespeicher dienende Induktivität $L_3$ wesentlich grösser ist als die Induktivität $L_1$.

Im Zeitpunkt $T_3$ oder danach wird nun beispielsweise der Prüfschalter 15 geöffnet, um dessen Abschaltvermögen im Bereich von Gleichströmen mit überlagertem transienten Anteil zu untersuchen. Es ist ferner jederzeit möglich, den Kurzschliesser 17 zu schliessen, wie es hier im Zeitpunkt $T_5$ geschieht, und damit von einem transient verlaufenden Strom i(t) überzugehen auf einen quasikonstanten Gleichstrom. Der durch den Prüfschalter 15 fliessende quasi-konstante Gleichstrom wird dann durch die in der Induktivität $L_3$ gespeicherte Energie geliefert. Sollte der Prüfschalter 15 beim Abschalten versagen, so wird sofort der Notschalter 12 eingelegt, welcher den Prüfschalter 15 überbrückt und vor Sekundärschäden bewahrt. Der Notschalter 12 kann von der Steuereinrichtung bei jedem Versuch automatisch nach einer sinnvoll bemessenen, erwarteten Ausschaltzeit des Prüfschalters 15 eingelegt werden, er kann aber auch von einem dem Prüfschalter 15 nachgeschalteten, nicht dargestellten Sensor betätigt werden. Die Strombahn, in welcher der Notschalter 12 liegt, ist besonders impedanzarm ausgebildet, um ein schnelles Kommutieren des Gleichstromes vom Prüfschalter 15 auf diese Strombahn sicherzustellen und so den Prüfschalter 15 optimal zu schützen.

Die tatsächliche Kontakttrennung des Prüfschalters 15, die Beeinflussung des Stromes i(t) während des Abschaltvorganges und der Abschaltaugenblick ist in Fig. 4 nicht dargestellt, da zu viele Variationsmöglichkeiten bestehen. Nach einer erfolgreichen Abschaltung des Stromes i(t) wird die wiederkehrende Spannung von der Induktivität $L_3$ bzw. von der in ihr gespeicherten Energie geliefert. Je nach Auslegung des Prüfkreises können 200 kv oder mehr auftreten. Eine Erhöhung dieses Spannungsniveaus ist jederzeit möglich, wenn die einzelnen Elemente des Prüfkreises entsprechend angepasst und dimensioniert werden. Je nach Auslegung der Energiequelle 1 können Gleichstromwerte von 10 kA und mehr erreicht werden, wenn auch die übrigen Prüfkreiselemente entsprechend ausgelegt sind.

Eine derartige exakte Uebereinstimmung des Verlaufes des Prüfstromes $i_p(t)$ mit dem Verlauf des Stromes $i(t)$, wie sie in Fig. 4 angedeutet ist, dürfte in den seltensten Fällen erreichbar sein. Der Zeitpunkt T, für das Einschalten des Draufschalters 2 kann variiert werden, und damit kann die Kurvenform des Prüfstromes $i_p(t)$ in einem weiten Bereich verändert werden.

Ebenso ist es möglich, wenn die Energiequelle 1 als Wechselstromgenerator ausgebildet ist, die Ausgangsfrequenz dieses Wechselstromgenerators zu verändern, und damit ebenfalls die Kurvenform des Prüfstromes $i_p(t)$ zu beeinflussen. Diese beiden Massnahmen können mit der Zuschaltung der Induktivität $L_2$ verknüpft werden, wobei zudem noch der Zeitpunkt $T_4$ für diese Zuschaltung variiert werden kann, wodurch eine weitere Vielfalt von möglichen Kurvenformen des Prüfstromes $i_p(t)$ erreicht wird. Eine hinreichend gute Annäherung der relevanten Stromverläufe wird durch eine Nutzung dieser Vielzahl von Möglichkeiten auf jeden Fall erreicht, so dass stets eine der Realität in einem Gleichstromnetzwerk entsprechende Belastung des Prüfschalters 15 vor, während und nach dessen Ausschaltvorgang gewährleistet ist.

In Fig. 2 ist ein gleich wirkender Prüfkreis wie in Fig. 1 dargestellt. Der einzige Unterschied ist der, dass die Wechselspannungsquelle über einen Transformator 20 auf den Induktivitätskreis 10 wirkt. Die Induktivität $L_2$ liegt auf der Unterspannungsseite dieses Transformators 20 und kann deshalb vorteilhaft für kleinere Betriebsspannungen ausgelegt werden.

In Fig. 3 ist ein Transformator 20 parallel zur Energiequelle 1 geschaltet. Parallel zum sekundärseitigen Ausgang dieses Transformators 20 ist die zuschaltbare Induktivität $L_2$ vorgesehen. Diese Anordnung weist den Vorteil auf, dass bei etwaigen Fehlern im Prüfkreis, die Fehlerströme durch die Impedanz des Transformators 20 etwas begrenzt werden, so dass Sekundärschäden klein gehalten bzw. vermieden werden können. Im übrigen wirkt dieser Prüfkreis gleich wie die bereits vorher beschriebenen Prüfkreise.

## Ansprüche

1. Prüfkreis für die Prüfung des Abschaltvermögens von Hochspannungs-Gleichstromschaltern (Prüfschalter 15), mit einer Energiequelle (1) und einem von der Energiequelle (1) beaufschlagten Induktivitätskreis (10), dadurch gekennzeichnet,
- dass parallel zur Energiequelle (1) mindestens eine zuschaltbare Induktivität ($L_2$) vorgesehen ist.

2. Prüfkreis nach Anspruch 1, dadurch gekennzeichnet,
- dass die Energiequelle (1) über einen Transformator (20) auf den Induktivitätskreis (10) wirkt.

3. Prüfkreis für die Prüfung des Abschaltvermögens von Hochspannungs-Gleichstromschaltern (Prüfschalter 15), mit einer Energiequelle (1) und einem von der Energiequelle (1) beaufschlagten Induktivitätskreis (10), dadurch gekennzeichnet,
- dass parallel zur Energiequelle (1) ein Transformator (20) geschaltet ist, und
- dass parallel zum sekundärseitigen Ausgang des Transformators (20) mindestens eine zuschaltbare Induktivität ($L_2$) vorgesehen ist.

4. Prüfkreis nach einem der Ansprüche 1 bis 3, dadurch gekennzeichnet,
- dass der Wert der zuschaltbaren Induktivität ($L_2$) veränderbar ist.

5. Prüfkreis nach einem der Ansprüche 1 bis 4, dadurch gekennzeichnet,
- dass die Energiequelle (1) als Wechselspannungsquelle ausgebildet ist.

6. Prüfkreis nach Anspruch 5, dadurch gekennzeichnet,
- dass für eine zeitgenaue Steuerung der Beaufschlagung des Induktivitätskreises (10) eine, bezogen auf die Phasenlage der an der Wechselspannungsquelle anstehenden Wechselspannung, einstellbare Steuereinrichtung vorgesehen ist.

7. Prüfkreis nach Anspruch 5, dadurch gekennzeichnet,
- dass als Wechselspannungsquelle mindestens ein Generator vorgesehen ist, dessen ausgangsseitige Frequenz einstellbar ist.

# FIG.1

# FIG.2

# FIG.3

FIG.4

Europäisches
Patentamt

# EUROPÄISCHER RECHERCHENBERICHT

Nummer der Anmeldung

EP 87 11 8883

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-C- 829 474 (ETS. MERLIN & GERIN S.A.) * Seite 2, Zeilen 12-25; Seite 2, Zeilen 42-48; Seite 3, Zeilen 6-14; Anspruch 2; Figur 1 * --- | 1,5,6 | G 01 R 31/32 |
| A | DE-B-1 021 479 (LICENTIA PATENTVERWALTUNGS GmbH) * Spalte 1, Zeile 48 - Spalte 2, Zeile 32; Figur 1 * --- | 1-3 | |
| A | DE-A-3 217 167 (BBC AG BROWN, BOVERI & CIE.) * Ansprüche 1,3,4; Figuren 1,3 * --- | 1-4 | |
| A | DE-B-1 049 002 (LICENTIA PATENT-VERWALTUNGS-GmbH) * Anspruch 2 * ----- | 7 | |

| | RECHERCHIERTE SACHGEBIETE (Int. Cl.4) |
|---|---|
| | G 01 R<br>H 01 H |

Der vorliegende Recherchenbericht wurde für alle Patentansprüche erstellt

| Recherchenort | Abschlußdatum der Recherche | Prüfer |
|---|---|---|
| DEN HAAG | 22-04-1988 | PENZKOFER, B. |